# EUROPEAN PATENT APPLICATION

(11) **EP 4 089 738 A1**
(43) Date of publication of application: **16.11.2022**
(21) Application number: 21744296.1
(22) Date of filing: 14.01.2021
(51) Int. Cl.: H01L 27/32, H01L 27/15

(54) **DISPLAY UNIT AND DISPLAY**

(30) Priority: 20.01.2020 CN 202010073896
(71) Applicant: Beijing Ivisual 3D Technology Co., Ltd., Beijing 100055 (CN); Visiotech Ventures Pte. Ltd., Singapore 188979 (SG)
(72) Inventor: DIAO, Honghao, Beijing 100055 (CN); HUANG, Lingxi, Singapore 188979 (SG)
(74) Representative: Manitz Finsterwald Patent- und Rechtsanwaltspartnerschaft mbB
(86) International application number: PCT/CN2021/071707
(87) International publication number: WO 2021/147759

(57) **Abstract**

The present application relates to the technical field of display, and discloses a display unit, comprising: an insulating layer, a conducting layer, and a light-transmissive carrier plate, and a light-emitting diode (LED) light-emitting structure and a light conversion layer, which are arranged between the insulating layer and the light-transmissive carrier plate, wherein the conducting layer is electrically connected with the LED light-emitting structure, and is electrically connected with a conductive through hole in the insulating layer. The present application further discloses a display. The display unit and the display disclosed in the present application avoid a peripheral wiring mode, thereby omitting a wiring frame, improving display effect, and reducing cost.

## Description

The present application claims priority to the Chinese Patent Application with an application number of 202010073896.1 and a title of *"Display Unit and Display",* filed to China National Intellectual Property Administration on January, 20th, 2020, the disclosures of which are hereby incorporated by reference.

### TECHNICAL FIELD

The present application relates to the technical field of display, and for example, relates to a display unit and a display.

### BACKGROUND

At present, when power supply, control and other wiring of light-emitting diode (LED) display apparatuses are designed, a peripheral wiring mode is usually adopted.

In a process of implementing embodiments of the present disclosure, at least the following problems are found in related technologies:
The peripheral wiring mode leads to existence of a wiring frame in the LED display apparatus, thereby affecting display effect and increasing cost.

### SUMMARY

In order to provide a basic understanding of some aspects of the disclosed embodiments, a brief summary is given below. The summary is not intended to be a general comment, nor to identify key/important components or describe the scope of protection of the embodiments, but to be a preface to the following detailed description.

Embodiments of the present disclosure provide a display unit and a display, to solve a technical problem that a peripheral wiring mode leads to existence of a wiring frame in an LED display apparatus, thereby affecting display effect and increasing cost.

The display unit provided by embodiments of the present disclosure comprises:
an insulating layer, a conducting layer, and a light-transmissive carrier plate, and
an LED light-emitting structure and a light conversion layer, which are arranged between the insulating layer and the light-transmissive carrier plate,
wherein the conducting layer is electrically connected with the LED light-emitting structure, and is electrically connected with a conductive through hole in the insulating layer.

In some embodiments, the light conversion layer may be arranged between the light-transmissive carrier plate and the LED light-emitting structure.

In some embodiments, the LED light-emitting structure may be partially or wholly arranged in the light conversion layer.

In some embodiments, when the LED light-emitting structure is partially arranged in the light conversion layer, the LED light-emitting structure may be arranged at one side, away from the light-transmissive carrier plate, of the light conversion layer.

In some embodiments, a peak wavelength of an excitation spectrum of the light conversion layer may comprise any wavelength or waveband greater than or equal to 200 nm and less than or equal to 480 nm.

In some embodiments, a wavelength of an emission spectrum of the light conversion layer may comprise any wavelength or waveband greater than or equal to 490 nm and less than or equal to 720 nm.

In some embodiments, the light conversion layer may comprise at least one of red light conversion materials, green light conversion materials, white light conversion materials, and blue light conversion materials.

In some embodiments, the light conversion materials may comprise fluorescent materials or quantum dot materials.

In some embodiments, the LED light-emitting structure may comprise a micro-LED light-emitting device.

In some embodiments, the micro-LED light-emitting device may comprise an N-type layer, an active layer, and a P-type layer.

In some embodiments, the active layer may comprise a quantum well layer.

In some embodiments, the conducting layer may be electrically connected with the N-type layer or the P-type layer.

In some embodiments, the conducting layer may be arranged between the light-transmissive carrier plate and the light conversion layer. Optionally, the conducting layer may be partially or wholly arranged in the light conversion layer. Optionally, the conducting layer may be arranged between the LED light-emitting structure and the insulating layer. Optionally, the conducting layer may be partially or wholly arranged in the insulating layer.

In some embodiments, the conducting layer may be electrically connected with conductive materials filled in the conductive through hole of the insulating layer.

In some embodiments, the conducting layer may comprise at least two layers of conductive lines.

In some embodiments, the conductive lines may be arranged in matrix.

In some embodiments, the conducting layer, the LED light-emitting structure, and the light conversion layer may be sequentially arranged from the insulating layer to the light-transmissive carrier plate.

In some embodiments, an end, away from the conducting layer, of the conductive through hole in the insulating layer may be electrically connected with a bonding part.

In some embodiments, the bonding part may comprise at least one of a bonding pad, a chip, a printed circuit board (PCB), a flexible circuit board (FPC), and a connector.

The display provided by embodiments of the present disclosure comprises the above display unit.

The display unit and the display provided by embodiments of the present disclosure may achieve the following technical effects:
The peripheral wiring mode is avoided, thereby omitting a wiring frame, improving display effect, and reducing cost.

The above general description and the following description are exemplary and explanatory only, and are not intended to limit the present application.

### DESCRIPTION OF DRAWINGS

One or more embodiments are illustrated by the corresponding drawings, and the illustrations and drawings do not limit the embodiments. Elements having the same reference numerals in the drawings are shown as similar elements, and the drawings are not intended to limit the scale, wherein:
Fig. 1 is a structural schematic diagram of a display unit provided by embodiments of the present disclosure;
Figs. 2A and 2B are schematic diagrams of arrangement of a light conversion layer provided by embodiments of the present disclosure, respectively;
Fig. 3 is a schematic diagram of arrangement of an LED light-emitting structure provided by embodiments of the present disclosure;
Fig. 4 is a structural schematic diagram of a micro-LED light-emitting device provided by embodiments of the present disclosure;
Figs. 5A, 5B, 5C, 5D, and 5E are schematic diagrams of arrangement of a conducting layer provided by embodiments of the present disclosure, respectively;
Fig. 6 is a schematic diagram of another arrangement of the conducting layer provided by embodiments of the present disclosure;
Fig. 7 is a schematic diagram of another arrangement of the conducting layer provided by embodiments of the present disclosure;
Fig. 8 is a schematic diagram of an insulating layer provided by embodiments of the present disclosure; and
Fig. 9 is a structural schematic diagram of a display provided by embodiments of the present disclosure.

### Reference numerals:

100: display unit; 110: insulating layer; 120: conducting layer; 130: light-transmissive carrier plate; 140: LED light-emitting structure; 150: light conversion layer; 160: conductive through hole; 170: N-type layer; 180: active layer; 190: P-type layer; 210: conductive material; 220: conductive line; 230: bonding part; and 240: display.

### DETAILED DESCRIPTION

To understand features and technical contents of embodiments of the present disclosure in more detail, implementation of the embodiments of the present disclosure is described in detail below with reference to accompanying drawings; and the accompanying drawings are used for reference only, rather than limiting the embodiments of the present disclosure. In following technical description, for the convenience of explanation, a thorough understanding of the disclosed embodiments is provided through more details. However, one or more embodiments may be implemented without the details. In other cases, to simplify the accompanying drawings, well-known structures and apparatuses may be shown simplistically.

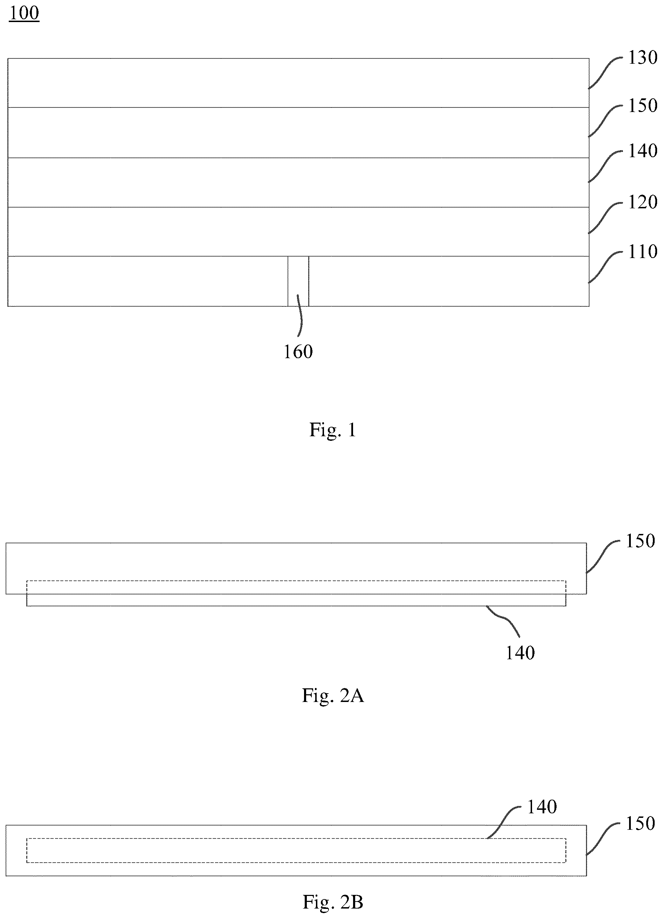

Referring to Fig. 1, embodiments of the present disclosure provide a display unit 100, comprising:
an insulating layer 110, a conducting layer 120, and a light-transmissive carrier plate 130, and
an LED light-emitting structure 140 and a light conversion layer 150, which are arranged between the insulating layer 110 and the light-transmissive carrier plate 130,
wherein the conducting layer 120 is electrically connected with the LED light-emitting structure 140, and is electrically connected with a conductive through hole 160 in the insulating layer 110.

In some embodiments, the number of conductive through holes 160 may be considered according to actual conditions such as process requirements.

In some embodiments, the light conversion layer 150 may be arranged between the light-transmissive carrier plate 130 and the LED light-emitting structure 140.

Referring to Fig. 2A, in some embodiments, the LED light-emitting structure 140 may be partially arranged in the light conversion layer 150.

Referring to Fig. 2B, in some embodiments, the LED light-emitting structure 140 may be wholly arranged in the light conversion layer 150.

In some embodiments, the LED light-emitting structure 140 may be partially arranged in the light conversion layer 150, or wholly arranged in the light conversion layer 150, according to actual conditions such as process requirements.

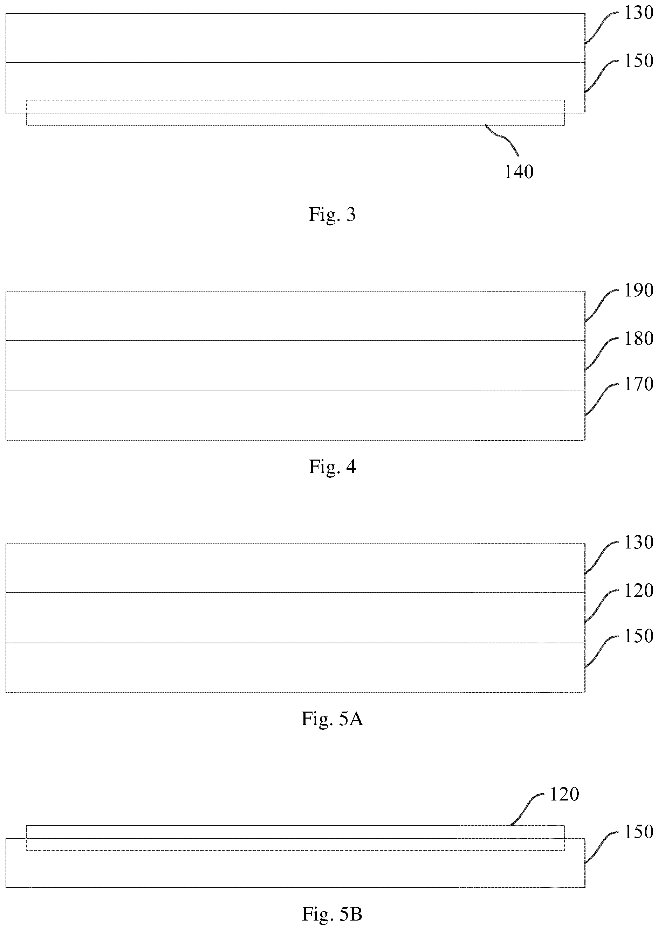

Referring to Fig. 3, in some embodiments, when the LED light-emitting structure 140 is partially arranged in the light conversion layer 150, the LED light-emitting structure 140 may be arranged at one side, away from the light-transmissive carrier plate 130, of the light conversion layer 150. Optionally, when the LED light-emitting structure 140 is partially arranged in the light conversion layer 150, the LED light-emitting structure 140 may also be arranged at one side, close to the light-transmissive carrier plate 130, of the light conversion layer 150.

In some embodiments, when the LED light-emitting structure 140 is partially arranged in the light conversion layer 150, the LED light-emitting structure 140 may be arranged at one side, away from the light-transmissive carrier plate 130, or one side, close to the light-transmissive carrier plate 130, of the light conversion layer 150, according to actual conditions such as process requirements.

In some embodiments, a peak wavelength of an excitation spectrum of the light conversion layer 150 may comprise any wavelength or waveband greater than or equal to 200nm and less than or equal to 480nm.

In some embodiments, a wavelength of an emission spectrum of the light conversion layer 150 may comprise any wavelength or waveband greater than or equal to 490nm and less than or equal to 720nm.

In some embodiments, the light conversion layer 150 may comprise at least one of red light conversion materials, green light conversion materials, white light conversion materials, and blue light conversion materials.

In some embodiments, the light conversion materials may comprise fluorescent materials or quantum dot materials.

In some embodiments, the light conversion layer 150 may contain epoxy resin, silicone glue and the like, in which the light conversion materials are mixed.

In some embodiments, the LED light-emitting structure 140 may comprise a micro-LED light-emitting device.

Referring to Fig. 4, in some embodiments, the micro-LED light-emitting device may comprise an N-type layer 170, an active layer 180, and a P-type layer 190. In Fig. 4, the arrangement sequence of the N-type layer 170, the active layer 180, and the P-type layer 190 is exemplarily shown. Optionally, the active layer 180 is generally arranged between the N-type layer 170 and the P-type layer 190.

In some embodiments, the active layer 180 may comprise a quantum well layer. Optionally, the quantum well layer may comprise at least one of a single quantum well layer and a multi-quantum well layer.

In some embodiments, the conducting layer 120 may be electrically connected with the N-type layer 170 or the P-type layer 190.

In some embodiments, the number of conductive through holes 160 may be considered according to the number of N-type layers 170 and P-type layers 190, and actual conditions such as process requirements.

Referring to Fig. 5A, in some embodiments, the conducting layer 120 may be arranged between the light-transmissive carrier plate 130 and the light conversion layer 150.

Referring to Fig. 5B, in some embodiments, the conducting layer120 may be partially arranged in the light conversion layer 150.

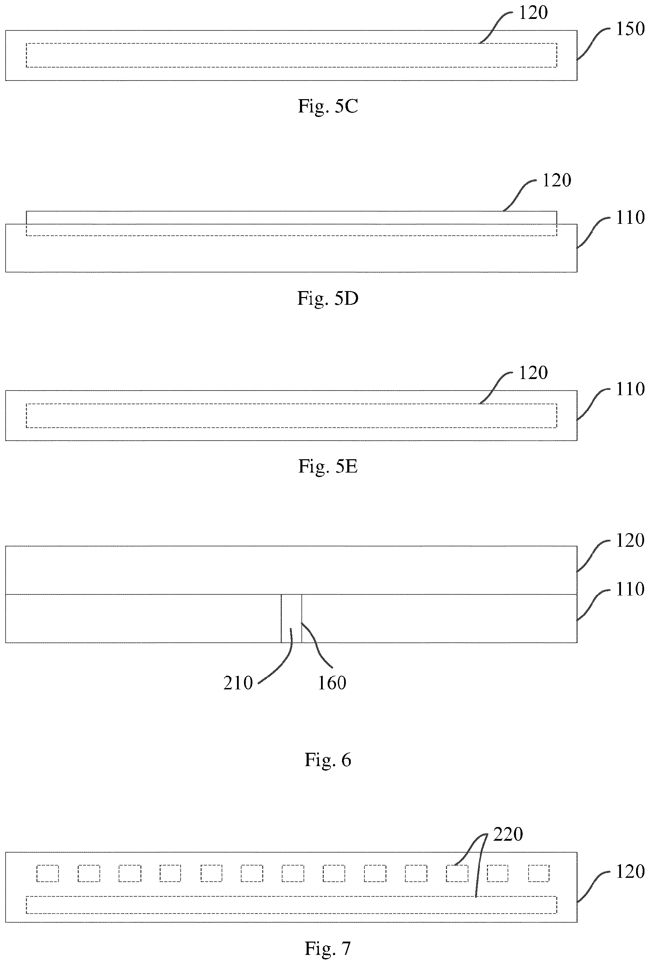

Referring to Fig. 5C, in some embodiments, the conducting layer 120 may be wholly arranged in the light conversion layer 150.

In some embodiments, the conducting layer 120 may be partially arranged in the light conversion layer 150, or wholly arranged in the light conversion layer 150, according to actual conditions such as process requirements.

Referring to Fig. 1, in some embodiments, the conducting layer 120 may be arranged between the LED light-emitting structure 140 and the insulating layer 110.

Referring to Fig. 5D, in some embodiments, the conducting layer120 may be partially arranged in the insulating layer 110.

Referring to Fig. 5E, in some embodiments, the conducting layer120 may be wholly arranged in the insulating layer 110.

In some embodiments, the conducting layer 120 may be partially arranged in the insulating layer 110, or wholly arranged in the insulating layer 110, according to actual conditions such as process requirements.

The above arrangement mode of the conducting layer 120 may be determined according to actual conditions such as process requirements, as long as normal conduction of the conducting layer 120 is not affected.

Referring to Fig. 6, in some embodiments, the conducting layer 120 may be electrically connected with conductive materials 210 filled in the conductive through hole 160 of the insulating layer 110. Optionally, the conductive materials 210 filled in the conductive through hole 160 may be a metal conducive to conduction, such as nickel and copper.

In some embodiments, the conductive materials 210 may be filled into hole walls of the conductive through hole 160. Optionally, the conductive materials 210 may also filled in the entire conductive through hole 160, as long as the conductive materials 210 can ensure conductivity of the conductive through hole 160.

Referring to Fig. 7, in some embodiments, the conducting layer 120 may comprise at least two layers of conductive lines 220. Only two layers of conductive lines 220 are taken as an example in Fig. 7. Optionally, the conducting layer 120 may comprise two, three or more layers of conductive lines 220.

In some embodiments, the conductive lines 220 may be arranged in matrix as shown in Fig. 7. Optionally, when the conducting layer 120 comprises at least two layers of conductive lines 220, a structural relationship of each layer of conductive lines 220 may be different from the matrix arrangement, but other arrangement modes.

In some embodiments, the number of conductive lines 220 included in the conducting layer 120 may be considered according to actual conditions such as process requirements; and arrangement modes of conductive lines 220 in different layers may also be considered according to actual conditions such as process requirements.

In some embodiments, the conductive lines 220 may be metal lines. Optionally, non-metals with conductivity may also be selected as the conductive lines 220.

Referring to Fig. 1, in some embodiments, the conducting layer 120, the LED light-emitting structure 140, and the light conversion layer 150 may be sequentially arranged from the insulating layer 110 to the light-transmissive carrier plate 130.

In some embodiments, an arrangement sequence different from the above may be considered according to actual conditions such as process requirements.

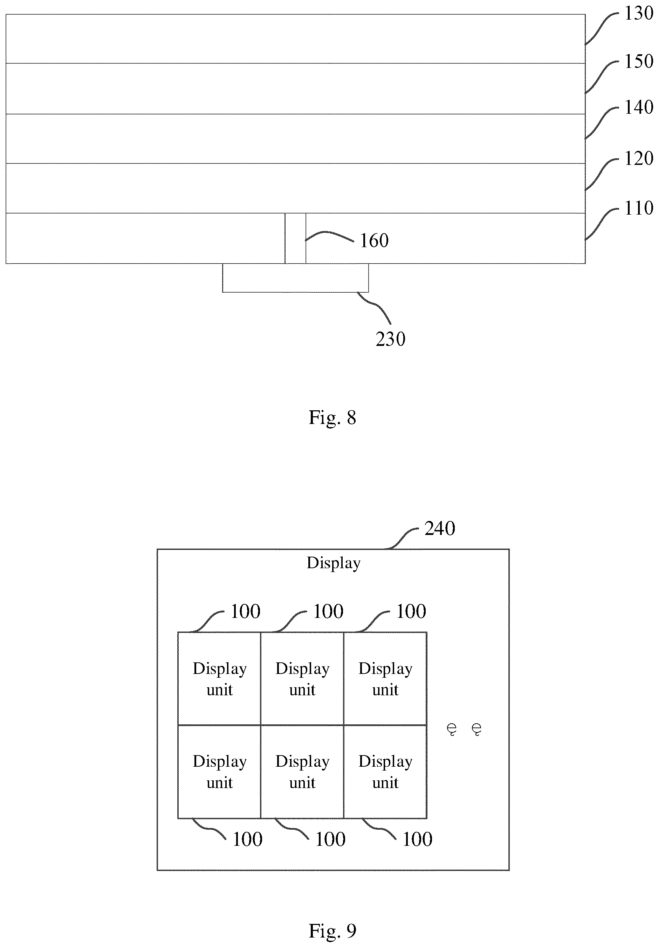

Referring to Fig. 8, in some embodiments, an end, away from the conducting layer 120, of the conductive through hole 160 in the insulating layer 110 may be electrically connected with a bonding part 230. Optionally, the bonding part 230 may be different devices with different functions; for example, the bonding part 230 may be a device for providing load, or the bonding part 230 may be a device for controlling the display unit 100, or the bonding part 230 may be a device for providing electrical connection, etc.

In some embodiments, the bonding part 230 may be a bonding pad, a chip, a PCB, a FPC, a connector or the like.

In some embodiments, different display units 100 may be spliced together. Optionally, the size of the bonding part 230 does not exceed coverage of the display units 100. Optionally, regardless of whether different display units 100 are spliced together, the size of the bonding part 230 can also exceed the coverage of the display units 100 without affecting peripheral devices.

In some embodiments, different modes of splicing the display units 100 together and the number of spliced display units 100 may be considered according to actual conditions such as process requirements. Optionally, whether the size of the bonding part 230 exceeds the coverage of the display units 100 may also be considered according to actual conditions such as process requirements. No matter how the display units 100 are spliced together or whether the size of the bonding part 230 exceeds the coverage of the display units 100, a wiring frame is absent between the two spliced display units 100.

In some embodiments, transparency of the light-transmissive carrier plate 130 may be set flexibly. Optionally, the transparency of different regions in the light-transmissive carrier plate 130 may be the same or different.

In some embodiments, the light-transmissive carrier plate 130 may be a glass carrier plate, a flexible material carrier plate, an organic resin carrier plate, a touch screen, a sapphire carrier plate or the like, as long as it can transmit light normally.

In some embodiments, the display unit 100 may perform 3D display.

Referring to Fig. 9, a display 240 provided by embodiments of the present disclosure comprises the display unit 100.

In some embodiments, the display 240 may perform 3D display.

In some embodiments, the display 240 may comprise at least one display unit 100; for example, the display 240 may comprise one, two, three or more display units 100. Optionally, a plurality of display units 100 constituting the display 240 may be arranged in a structure of array.

In some embodiments, in the display 240 composed of more than two display units 100, the wiring frame is absent between the two spliced display units 100.

The display unit and the display provided by the embodiments of the present disclosure avoid a peripheral wiring mode, thereby omitting the wiring frame, improving display effect, and reducing cost.

The above description and drawings sufficiently illustrate the embodiments of the present disclosure to enable those skilled in the art to practice them. Other embodiments may comprise structural, logical, electrical, process, and other changes. The embodiments represent only possible changes. Unless expressly required, individual components and functions are optional and the order of operations may be changed. Parts and features of some embodiments may be included in or substituted for parts and features of other embodiments. The scope of the disclosed embodiments includes the full scope of the claims, and all available equivalents of the claims. When used in the present application, although the terms of "first", "second", etc. may be possibly used in the present application to describe various elements, these elements should not be limited by these terms. These terms are only used to distinguish one element from another. For example, without changing the meaning of the description, a first element may be called as a second element, and similarly, the second element may be called as the first element, as long as all of "the first elements" that appear are consistently renamed and all of "the second elements" that appear are consistently renamed. The first element and the second element are both elements, but may not be the same element. Moreover, the terms used in the present application are used to describe the embodiments only and not to limit the claims. As used in the illustration of the embodiments and the claims, unless clearly indicated in the context, the singular forms "a", "an" and "the" are also intended to include the plural forms. Similarly, the term "and/or" as used in the present application is meant to include any and all possible combinations of one or more of the associated listings. In addition, when used in the present application, the term "comprise" and its variations "comprises" and/or "comprising", etc., refer to the presence of stated features, integers, steps, operations, elements, and/or components, but does not preclude the presence or addition of one or more other features, integers, steps, operations, elements, components and/or groupings of these. Without further limitations, an element limited by the phrase "comprises a..." does not preclude the presence of additional identical elements in the process, method or device that includes the element. Herein, the difference of each embodiment from each other may be the focus of explanation. The same and similar parts among all of the embodiments may be referred to each other. For the method and product disclosed by the embodiments, if the method and product correspond to a method part disclosed by the embodiments, the description of the method part can be referred to for the related part.

In the embodiments disclosed herein, the disclosed method and product (including, but not limited to the apparatus and the device) may be realized in other ways. For example, the device embodiments described above are merely schematic. For example, the division of the units may be only a logical functional division, and may be an additional division manner in actual realization. For example, multiple units or components may be combined or integrated into another system, or some features may be ignored or not executed. In addition, the displayed or discussed mutual coupling or direct coupling or communication connection may be indirect coupling or communication connection through some interfaces, devices or units, and may be electrical, mechanical or other forms. The units described as separate components may or may not be physically separated, and the components shown as the units may or may not be physical units, that is, may be located in one place, or may be distributed on multiple network units. The present embodiments may be implemented by selecting some or all of the units according to actual needs. In addition, each functional unit in the embodiments of the present disclosure may be integrated into one processing unit, or each unit may exist physically alone, or two or more units may be integrated into one unit.

## Claims

1. A display unit, comprising:
an insulating layer, a conducting layer, and a light-transmissive carrier plate, and
a light-emitting diode (LED) light-emitting structure and a light conversion layer, which are arranged between the insulating layer and the light-transmissive carrier plate,
wherein the conducting layer is electrically connected with the LED light-emitting structure, and is electrically connected with a conductive through hole in the insulating layer.

2. The display unit according to claim 1, wherein
the light conversion layer is arranged between the light-transmissive carrier plate and the LED light-emitting structure; or
the LED light-emitting structure is partially or wholly arranged in the light conversion layer.

3. The display unit according to claim 2, wherein when the LED light-emitting structure is partially arranged in the light conversion layer, the LED light-emitting structure is arranged at one side, away from the light-transmissive carrier plate, of the light conversion layer.

4. The display unit according to claim 1, wherein
a peak wavelength of an excitation spectrum of the light conversion layer comprises any wavelength or waveband greater than or equal to 200 nm and less than or equal to 480 nm; or
a wavelength of an emission spectrum of the light conversion layer comprises any wavelength or waveband greater than or equal to 490 nm and less than or equal to 720 nm.

5. The display unit according to claim 4, wherein the light conversion layer comprises at least one of red light conversion materials, green light conversion materials, white light conversion materials, and blue light conversion materials.

6. The display unit according to claim 5, wherein the light conversion materials comprise fluorescent materials or quantum dot materials.

7. The display unit according to claim 1, wherein the LED light-emitting structure comprises a micro-LED light-emitting device.

8. The display unit according to claim 7, wherein the micro-LED light-emitting device comprises an N-type layer, an active layer, and a P-type layer.

9. The display unit according to claim 8, wherein the active layer comprises a quantum well layer.

10. The display unit according to claim 8, wherein the conducting layer is electrically connected with the N-type layer or the P-type layer.

11. The display unit according to any one of claims 1-10, wherein
the conducting layer is arranged between the light-transmissive carrier plate and the light conversion layer; or
the conducting layer is partially or wholly arranged in the light conversion layer; or
the conducting layer is arranged between the LED light-emitting structure and the insulating layer; or
the conducting layer is partially or wholly arranged in the insulating layer.

12. The display unit according to claim 11, wherein the conducting layer is electrically connected with conductive materials filled in a conductive through hole of the insulating layer.

13. The display unit according to claim 11, wherein the conducting layer comprises at least two layers of conductive lines.

14. The display unit according to claim 13, wherein the conductive lines are arranged in matrix.

15. The display unit according to claim 1, wherein the conducting layer, the LED light-emitting structure, and the light conversion layer are sequentially arranged from the insulating layer to the light-transmissive carrier plate.

16. The display unit according to any one of claims 1-15, wherein an end, away from the conducting layer, of a conductive through hole in the insulating layer is electrically connected with a bonding part.

17. The display unit according to claim 16, wherein the bonding part comprises at least one of a bonding pad, a chip, a printed circuit board (PCB), a flexible circuit board (FPC), and a connector.

18. A display, comprising the display unit of any one of claims 1-17.
